(19) Europäisches Patentamt
European Patent Office
Office européen des brevets

(11) **EP 4 503 250 A1**

(12) **EUROPEAN PATENT APPLICATION**
published in accordance with Art. 153(4) EPC

(43) Date of publication:
05.02.2025 Bulletin 2025/06

(21) Application number: 23794829.4

(22) Date of filing: 15.03.2023

(51) International Patent Classification (IPC):
*H01M 10/42* (2006.01)   *H01M 10/48* (2006.01)
*B60L 58/10* (2019.01)

(52) Cooperative Patent Classification (CPC):
Y02T 10/70

(86) International application number:
PCT/CN2023/081670

(87) International publication number:
WO 2023/207393 (02.11.2023 Gazette 2023/44)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 27.04.2022 CN 202210458752

(71) Applicant: Autel Intelligent Technology Corp., Ltd.
Shenzhen City 518000 (CN)

(72) Inventor: WANG, Weilin
Shenzhen, Guangdong 518055 (CN)

(74) Representative: Harris, Oliver John Richard
Novagraaf UK
Centrum
Norwich Research Park
Colney Lane
Norwich NR4 7UG (GB)

(54) **POWER BATTERY MONITORING SYSTEM AND METHOD**

(57) The present application relates to a power battery monitoring system and method. The system comprises a battery module, N monitoring modules and an upper monitoring platform. The N monitoring modules are connected in series with each other, and a first monitoring module is connected with the upper monitoring platform, wherein the number of sampling channels of each monitoring module is M. The power battery monitoring system can segment the battery cells; the number of the battery cells in each segment is M; the battery cells in each segment are connected with the same monitoring module; and the monitoring modules obtain the sampling data of the battery cells in this segment through the corresponding sampling channel, so as to realize the monitoring of the battery cells in this segment by the upper monitoring platform. At the same time, each monitoring module can also be connected in series to achieve the expansion of the monitoring modules. Therefore, the power battery monitoring system can select the number of the monitoring modules according to the specific number of the battery cells, is compatible with the battery modules with various configurations, and has better compatibility.

FIG. 1

**Description**

**CROSS-REFERENCE TO RELATED APPLICATIONS**

The present application claims the priority from Chinese patent application No. 202210458752.7, titled "power battery monitoring system and method", filed on April 27, 2022 to China National Intellectual Property Administration, the disclosures of which are hereby incorporated by reference.

**TECHNICAL FIELD**

The present application relates to the field of power batteries, in particular to a power battery monitoring system and method.

**BACKGROUND**

The power battery of a new energy vehicle is formed by that a plurality of battery modules are connected in series or connected in parallel and then connected in series. Each battery module is formed by that a plurality of battery cells are connected in series (or connected in parallel and then connected in series). When the power battery is charged and discharged, the voltage of each battery cell and the temperature of the battery modules must be monitored to ensure that the voltage of each battery cell and the temperature of the battery modules are within a normal working range to prevent overcharge, overdischarge or overtemperature, which can cause damage to the battery.

Generally, sampling lines are led from both ends of the battery cell and a temperature sensor to monitor the voltage of the battery cell and the temperature of the battery modules. The battery modules from different manufacturers or vehicle models have very different configurations, and are generally composed of at least 3 strings of battery cells and at most dozens or hundreds of strings of battery cells. The existing power battery monitoring system cannot be compatible with different types of battery modules and has poor compatibility.

**SUMMARY**

Embodiments of the present application solve at least one of the above technical problems to a certain extent. Thus, the present application provides a power battery monitoring system and method, which can monitor various types of battery modules and have better compatibility.

In a first aspect, embodiments of the present application provide a power battery monitoring system. The power battery monitoring system comprises a battery module, N monitoring modules and an upper monitoring platform:

wherein the battery module comprises a plurality of battery cells connected in series and parallel;
the N monitoring modules are connected in series with each other, and a first monitoring module is connected with the upper monitoring platform, wherein the number of sampling channels of each monitoring module is M; M battery cells are connected with the same monitoring module through the M sampling channels; a sequence of the M sampling channels is consistent with a sequence of the M battery cells; M and N are integers greater than or equal to 1 respectively; and the monitoring modules are used for obtaining the sampling data of the battery cells;
the upper monitoring platform is used for monitoring the battery modules according to the sampling data.

In some embodiments, the sampling data comprises voltage or the voltage and temperature, and the monitoring modules comprise a voltage sampling unit, a temperature sampling unit and a first controller;

one end of the voltage sampling unit is connected with the battery cell through the sampling channel, and the other end is connected with the first controller for sampling the voltage of the battery cell;
one end of the temperature sampling unit is connected with the battery cells through the sampling channels, and the other end is connected with a first controller for sampling the temperature of the battery cells; and
the first controller is also connected with the upper monitoring platform, and the first controller is used for obtaining the voltage or the voltage and the temperature.

In some embodiments, the M sampling channels are voltage sampling channels; or, the M-P sampling channels are the voltage sampling channels, and the P sampling channels are temperature sampling channels; or the M-R sampling channels are the voltage sampling channels, and the R sampling channels are multiplexing sampling channels.

In some embodiments, the temperature sampling unit adopts a PTC resistor or an NTC resistor.

In some embodiments, the monitoring modules further comprise a first communication unit, the first communication unit is in communication connection with the first controller and the upper monitoring platform respectively, and a communication type is CAN communication or CAN FD communication.

In some embodiments, the upper monitoring platform comprises a second controller and a second communication unit;

the second communication unit is in communication connection with the monitoring modules and the second controller respectively to obtain the sampling data;
the second controller is used for monitoring the battery modules according to the sampling data.

In some embodiments, the battery cells and the monitoring modules are connected by cable plugs.

In a second aspect, embodiments of the present application provide a power battery monitoring method applied to the above power battery monitoring system. The method comprises:

obtaining the parameter information of the monitoring modules by the upper monitoring platform;
establishing, by the upper monitoring platform, a mapping relationship of the parameter information, communication addresses and weights of the monitoring modules through a bootstrap algorithm;
obtaining, by the monitoring modules, the sampling data of the battery cells, and determining serial numbers of the corresponding battery cells in the monitoring modules according to the sampling data;
in some embodiments, when the battery cell is abnormal, determining, by the upper monitoring platform, a location of the abnormal battery cell according to the serial number of the corresponding battery cell in the monitoring module and the mapping relationship, and monitoring the battery cell.

In some embodiments, the parameter information of the monitoring modules comprises the number of the voltage sampling channels and the number of the temperature sampling channels; and before the upper monitoring platform obtains the parameter information of the monitoring modules, the method further comprises:
obtaining, by the monitoring modules, a first voltage through the sampling channel; if the first voltage is greater than a first preset threshold or the first voltage is less than a second preset threshold, determining that the sampling channel is the voltage sampling channel and counting the number of the voltage sampling channels; determining the remaining sampling channels as the temperature sampling channel; and counting the number of the temperature sampling channels.

In some embodiments, establishing, by the upper monitoring platform, a mapping relationship of the parameter information, communication addresses and weights of the monitoring modules through a bootstrap algorithm comprises:

arranging, by the upper monitoring platform, the monitoring modules according to an ascending order of the weights through the bootstrap algorithm;
establishing the mapping relationship of the parameter information and the communication addresses of the monitoring modules according to an arrangement sequence.

In some embodiments, obtaining, by the monitoring modules, the sampling data of the battery cells, and determining serial numbers of the corresponding battery cells in the monitoring modules according to the sampling data comprises:

determining, by the monitoring module, an insertion sequence of the sampling channels according to the sampling data;
determining, by the monitoring modules, the serial number of the battery cell corresponding to the sampling data in the monitoring modules according to the insertion sequence of the sampling channels.

In some embodiments, determining, by the upper monitoring platform, a location of the abnormal battery cell according to the serial number of the corresponding battery cell in the monitoring module and the mapping relationship comprises:

if the abnormal battery cell corresponds to the kth monitoring module, obtaining, by the upper monitoring platform, the number of the sampling channels of the first k-1 monitoring modules according to the mapping relationship;
determining the location of the abnormal battery cell through the following formula:

$$C(n) = \sum_{1}^{k-1} M(k) + i$$

wherein M(k) is the number of the sampling channels of the kth monitoring module, i is the serial number of the abnormal battery cell in the kth monitoring module, and C(n) is the serial number of the location of the abnormal battery cell in all the battery cells.

In a third aspect, embodiments of the present application provide a power battery monitoring device, comprising at least one processor; and a memory in communication connection with the at least one processor, wherein the memory stores instructions that can be executed by the at least one processor, and the instructions are executed by the at least one processor to enable the at least one processor to perform any of the power battery monitoring methods.

In a fourth aspect, embodiments of the present application provide a computer-readable storage medium, wherein the computer-readable storage medium stores computer-executable instructions which are used to enable a computer to perform the power battery monitoring method.

Compared with the prior art, the present application has at least the following beneficial effects: The power battery monitoring system in the present application comprises the battery module, the N monitoring modules and the upper monitoring platform. The N monitoring modules are connected in series with each other, and the first monitoring module is connected with the upper monitoring platform, wherein the number of the sampling channels of each monitoring module is M; M battery cells are connected with the same monitoring module through the M sampling channels; and the sequence of the M sampling channels is consistent with the sequence of the M battery cells. Therefore, the monitoring modules can obtain the sampling data of the M battery cells through the M sampling channels and send the sampling data to the upper monitoring platform. The upper monitoring platform monitors the battery modules according to the sampling data.

The power battery monitoring system can segment the battery cells; the number of the battery cells in each segment is M; the battery cells in each segment are connected with the same monitoring module; and the monitoring modules obtain the sampling data of the battery cells in this segment through the corresponding sampling channel, so as to realize the monitoring of the battery cells in this segment by the upper monitoring platform. At the same time, each monitoring module can also be connected in series to achieve the expansion of the monitoring modules. Therefore, the power battery monitoring system can select the number of the monitoring modules according to the specific number of the battery cells, is compatible with the battery modules with various configurations, and has better compatibility.

## BRIEF DESCRIPTION OF THE DRAWINGS

One or more embodiments are described exemplarily through pictures in drawings corresponding thereto. The exemplary descriptions are not intended to limit the embodiments. Elements having the same reference number labels in the drawings are expressed as similar elements. The diagrams in the drawings do not limit a proportion unless otherwise specified.

Fig. 1 is a structural schematic diagram of a power battery monitoring system provided by an embodiment of the present application;

Fig. 2 is a structural schematic diagram of a monitoring module and an upper monitoring platform provided by an embodiment of the present application;

Fig. 3 is a flow chart of a power battery monitoring method provided by an embodiment of the present application;

Fig. 4 is a flow chart of step S32 in Fig. 3;

Fig. 5 is a flow chart of step S33 in Fig. 3;

Fig. 6 is a flow chart of step S34 in Fig. 3;

Fig. 7 is a structural schematic diagram of a power battery monitoring device provided by an embodiment of the present application;

Fig. 8 is a structural schematic diagram of a first controller provided by an embodiment of the present application; and

Fig. 9 is a structural schematic diagram of a second controller provided by an embodiment of the present application.

## DETAILED DESCRIPTION OF THE INVENTION

To make the purpose, the technical solution and the advantages of the present application more clear, the present application will be further described below in detail in combination with the drawings and the embodiment. It should be understood that specific embodiments described herein are only used for explaining the present application, not used for limiting the present application. Based on the embodiments in the present application, all other embodiments obtained by those ordinary skilled in the art without contributing creative labor will belong to the protection scope of the present application.

It should be noted that if there is no conflict, the features in the embodiments of the present application can be mutually combined, and are within the protection scope of the present application. In addition, although the functional modules are divided in the device diagram and the logical sequence is shown in the flow chart, in some cases, the steps shown or described can be performed in a different module division in the device or different sequence in the flow chart. Furthermore, the words "first", "second" and "third" used in the present application do not limit the data and the sequence of execution, but only distinguish the same or similar items with basically the same function and effect.

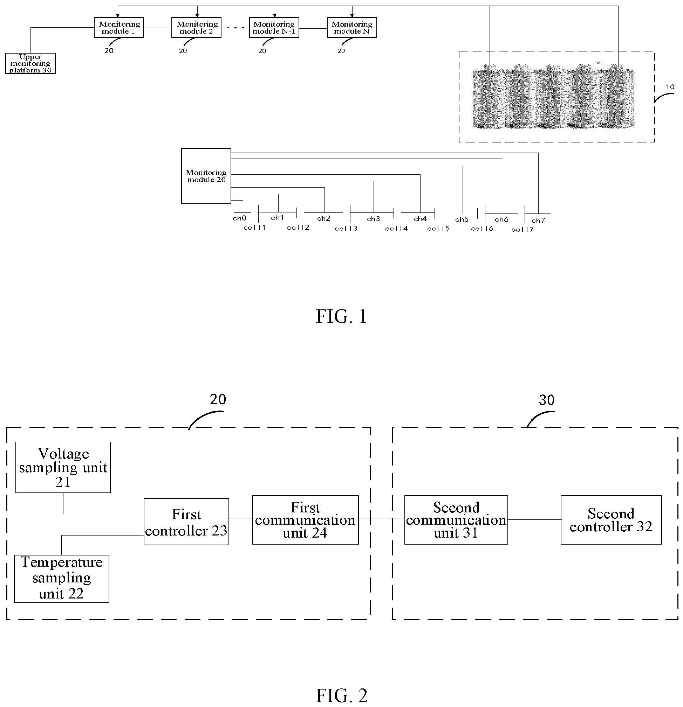

As shown in Fig. 1, Fig. 1 is a structural schematic diagram of a power battery monitoring system provided by an embodiment of the present application. As shown in Fig. 1, the power battery monitoring system comprises a battery module 10, N monitoring modules 20 and an upper monitoring platform 30. The battery module 10 comprises a plurality of battery cells connected in series and in parallel. Different battery modules 10 comprise different number of battery cells. The plurality of battery cells can be connected in parallel to increase the capacity of the battery cells, and can be then connected in series to form a battery module 10 to increase the total voltage value of the battery module 10.

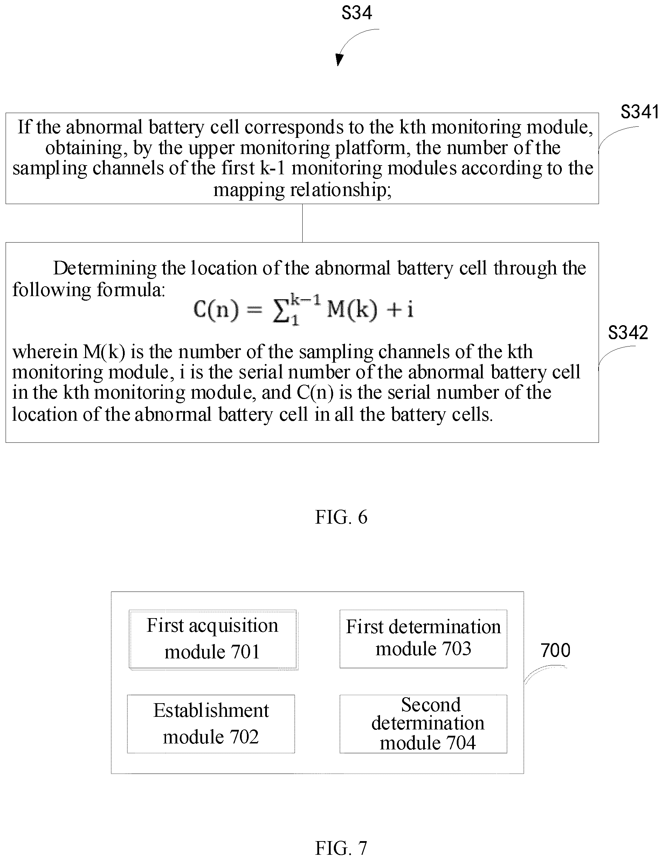

Different battery modules 10 comprise different number of battery cells, and thus need different number of sampling channels and monitoring modules 20. One sampling cable is shared between two adjacent battery cells. M+1 sampling cables are required by M battery cells. As shown in Fig. 1, 7 battery cells, i.e., cell 1-cell 7 respectively, require 8 sampling cables. If the voltage of the battery cells needs to be sampled, 7 sampling channels are required.

N monitoring modules 20 are connected in series, and the first monitoring module 20 is connected to the upper monitoring platform 30, and electrically connected to the upper monitoring platform 30, so that the upper monitoring platform 30 can supply power to the monitoring module 20, and can also supply power to the monitoring module 20 through an external power supply. The first monitoring module 20 is also in communication connection with the upper monitoring platform 30 to transmit the sampling data of the battery cells to the upper monitoring platform 30, so that the upper monitoring platform 30 monitors the battery module 10 according to the sampling data. Wherein the sampling data comprises voltage or voltage and temperature. In some other embodiments, the sampling data may also comprise parameters such as current.

The number of the sampling channels of each monitoring module 20 is M, and M battery cells are connected with the same monitoring module 20 through M sampling channels. The sequence of the M sampling channels is consistent with the sequence of the M battery cells. The monitoring module 20 is used for obtaining the sampling data of the battery cells through the sampling channels.

For example, as shown in Fig. 1, M is 7, so 7 sampling channels are connected with the same monitoring module 20, and the sequence of the 7 sampling channels is consistent with the sequence of the 7 battery cells, from cell 1-cell 7.

The M sampling channels can be used to obtain the sampling data, or some sampling channels can be deprecated. For example, if M is 24, i.e., the number of the sampling channels of the monitoring module 20 is 24, but the number of the battery cells is 7, then only 7 sampling channels are used in the monitoring module 20 to obtain the sampling data of the battery cells and other sampling channels are deprecated. Moreover, the sequence of the sampling channels is consistent with the sequence of the battery cells.

The first monitoring module 20 is a monitoring module 1, and the last monitoring module 20 is a monitoring module N. The monitoring module 1 to the monitoring module N are connected in series, and the monitoring module 1 is connected with the upper monitoring platform 30.

If there are many battery cells, the battery cells can be segmented. The number of the battery cells in each segment can be consistent with the number of the sampling channels of one monitoring module 20. However, the battery cells in each segment are not necessarily connected according to the sequence of the monitoring modules 2. For example, the battery cells in the first segment are connected with the monitoring module 2, the battery cells in the second segment are connected with the monitoring module 4, the battery cells in the third segment are connected with the monitoring module 1, and the battery cells in the fourth segment are connected with the monitoring module 3. The upper monitoring platform 30 can automatically identify the sequence of each monitoring module 20 and the sequence of the corresponding battery cell connected with the monitoring module 20 through the bootstrap algorithm, which is more convenient for users to use.

The upper monitoring platform 30 obtains the sampling data sent by the monitoring modules 20 and monitors the battery modules 10 according to the sampling data. For example, it is determined whether the battery cell is abnormal according to the sampling data; if the battery cell is abnormal, the location of the abnormal battery cell is determined. Abnormal conditions can include, but are not limited to, overvoltage, overcharge, overcurrent, and temperature anomalies.

The upper monitoring platform 30 can be achieved by a separate upper computer or achieved by a charge and discharge machine which is used to charge and discharge the battery modules 10 and monitor the battery modules 10 at the same time. The monitoring modules 20 are used for obtaining the sampling data of the battery cells, which is equivalent to separating the sampling part of the battery modules 10 from the inside of the charging and discharging machine, so that the users can select different types of monitoring modules 20 and the number of the monitoring modules 20 according to the configuration of different battery modules 10, and the monitoring modules 20 can be compatible with different types of battery modules 10, which also makes the design of the charge and discharge machine more miniaturized.

The types of the sampling channels can comprise voltage sampling channels, current sampling channels, temperature sampling channels and multiplexing sampling channels. In some embodiments, the M sampling channels are voltage sampling channels, and then sampling data is voltage. In some embodiments, the M-P sampling channels are the voltage sampling channels, the P sampling channels are the temperature sampling channels, and then the sampling data are voltage and temperature. In some embodiments, the M-R sampling channels are the voltage sampling channels, and the R sampling channels are the multiplexing sampling channels. The multiplexing sampling channels can be used for transmitting voltage, and can also be used for transmitting temperature. The monitoring modules 20 can configure the specific purpose of the multiplexing sampling channels as needed, and then the sampling data is voltage or voltage and temperature. Wherein P and R are integers greater than or equal to 1. For example, if M is 24, a monitoring module 20 can support 24 voltage sampling channels, or simultaneously support 20 voltage sampling channels, 4 temperature sampling channels, or 16 voltage sampling channels and 8 multiplexing sampling channels.

To sum up, the power battery monitoring system can segment the battery cells; the number of the battery cells in each segment is M; the battery cells in each segment are connected with the same monitoring module 20; and the monitoring modules 20 obtain the sampling data of the battery cells in this segment through the corresponding sampling channel, so as to realize the monitoring of the battery cells in this segment by the upper monitoring platform 30. At the same time, each monitoring module 20 can also be connected in series to achieve the expansion of the monitoring modules 20. Therefore, the power battery monitoring system can select the number of the monitoring modules 20 according to the specific number of the battery cells, is compatible with the battery modules 10 with various configurations, and has better compatibility.

As shown in Fig. 2, Fig. 2 is a structural schematic diagram of a monitoring module provided by an embodiment of the present application. As shown in Fig. 2, the monitoring module 20 comprises a voltage sampling unit 21, a temperature sampling unit 22 and a first controller 23.

One end of the voltage sampling unit 21 is connected with the battery cell through the sampling channel, and the other end is connected with the first controller 23 for sampling the voltage of the battery cell. One end of the temperature sampling unit 22 is connected with the battery cells through the sampling channels, and the other end is connected with the first controller 23 for sampling the temperature of the battery cells. The first controller 23 is also connected with the upper monitoring platform 30, and the first controller 23 is used for obtaining the voltage or the voltage and the temperature.

Wherein the voltage sampling unit 21 and the temperature sampling unit 22 can be any device capable of realizing the corresponding sampling function. In some embodiments, the temperature sampling unit 22 adopts a PTC resistor or an NTC resistor, and the voltage sampling unit 21 may adopt a voltage sampling sensor.

In some embodiments, the first controller 23 can be a general purpose processor, a digital signal processor (DSP), an application-specific integrated circuit (ASIC), a field programmable gate array (FPGA), a single-chip microcomputer, an ARM (Acorn RISC Machine) or other programmable logic devices, a discrete gate or transistor logic, a discrete hardware component, or any combination of these components. Furthermore, the first controller 23 can be any traditional processor, controller, microcontroller or state machine. The first controller 23 may also be implemented as a combination of computing devices, for example, a combination of DSP and microprocessor, multiple microprocessors, one or more microprocessors combined with DSP and/or any other such configuration. The first controller 23 can also be an inverter board or a main control board of a washing machine.

In some embodiments, the monitoring modules 20 further comprise a first communication unit 24, the first communication unit 24 is in communication connection with the first controller 23 and the upper monitoring platform 30 respectively, and a communication type is CAN communication or CAN FD communication. In other embodiments, the communication type may also be other communication modes other than CAN.

If a plurality of monitoring modules 20 are connected in series, the first controller 23 can be in communication connection with the first monitoring module 20 through the first communication unit 24, and the first monitoring module 20 can be in communication connection with the communication units of other monitoring modules 20 through the first communication unit 24. In other embodiments, the first controller 23 is in direct communication connection with the communication units of all monitoring modules 20 to receive the sampling data of the battery modules 10 transmitted by the corresponding monitoring modules 20.

In some embodiments, continuing to see Fig. 2, the upper monitoring platform 30 comprises a second controller 32 and a second communication unit 31; the second communication unit 31 is in communication connection with the monitoring modules 20 and the second controller 32 respectively, and specifically connected with the first communication unit 24 to obtain the sampling data; and the second controller 32 is used for monitoring the battery modules 10 according to the sampling data.

The second controller 32 can determine whether the battery cell in the battery module 10 has abnormal conditions such as overcharge, overvoltage or overtemperature according to the sampling data. If the abnormal condition is determined, a corresponding control command is issued to protect the battery module 10.

The upper monitoring platform 30 can also automatically identify the sequence of the connected monitoring module 20, and register the segmenting sequence of the battery cell connected with the monitoring module 20 through the bootstrap algorithm by the connection information of the sampling channels, so as to ensure that the sequence of the registered monitoring modules 20 is consistent with the sequence of the battery cells in the battery modules 10. For

# EP 4 503 250 A1

example: the monitoring module 1 is connected with the battery cell in the second segment, the monitoring module 2 is connected with the battery cell in the first segment, and the monitoring module 3 is connected with the battery cell in the third segment. Then, the upper monitoring platform 30 can identify the sequence of the corresponding battery cells connected with the monitoring modules 20 through the bootstrap algorithm, and the sequence of the registered modules is the monitoring module 2, the monitoring module 1 and the monitoring module 3, to ensure that the registration sequence is consistent with the segmentation sequence of the battery cells. Therefore, no matter whether the user accesses the upper monitoring platform 30 according to the sequence of the monitoring modules 20, the upper monitoring platform 30 can automatically identify the sequence of the monitoring modules 20, which is more convenient for the users to operate.

In some embodiments, the second controller 32 can be a general-purpose processor, a digital signal processor (DSP), an application-specific integrated circuit (ASIC), a field programmable gate array (FPGA), a single-chip microcomputer, an ARM (Acorn RISC Machine) or other programmable logic devices, a discrete gate or transistor logic, a discrete hardware component, or any combination of these components. Furthermore, the second controller 32 can be any traditional processor, controller, microcontroller or state machine. The second controller 32 may also be implemented as a combination of computing devices, for example, a combination of DSP and microprocessor, multiple microprocessors, one or more microprocessors combined with DSP and/or any other such configuration. The second controller 32 can also be an inverter board or a main control board of a washing machine.

The battery cells are connected with the monitoring modules 20 through cable plugs. One end of the cable plugs is connected with the battery cells. The sampling channels in the cable plugs are in the same sequence as that of the battery cells. For example: please continuing to refer to Fig. 1, the number of the battery cells in a certain segment is 7, and the sequence of the battery cells is cell 1-cell 7. Then, the sampling channels in the cable plugs are in the same sequence as that of the battery cells, and 8 sampling cables are required. The first sampling channel corresponds to ch0 sampling point and ch1 sampling point, and the second sampling channel corresponds to ch1 sampling point and ch2 sampling point, and so on. The seventh sampling channel corresponds to ch6 sampling point and ch7 sampling point. The other end of the cable plugs is connected with the monitoring modules 20. The cable plugs can be inserted into the monitoring modules 20 in a positive sequence or in a reverse sequence. The monitoring modules 20 can automatically detect the positive and negative insertion sequence, which is convenient for the users to operate.

After the cable plug is connected to the monitoring module 20, the monitoring module 20 can also automatically detect the type of the sampling channel. If it is a voltage sampling channel, it is specially used to sample the voltage of the battery cell. If the voltage sampling channel is determined, then a P line (with lowest voltage) and a Q line (with highest voltage) in the channel can be determined.

To sum up, the power battery monitoring system can segment the battery cells; the number of the battery cells in each segment is M; the battery cells in each segment are connected with the same monitoring module 20; and the monitoring modules 20 obtain the sampling data of the battery cells in this segment through the corresponding sampling channel, so as to realize the monitoring of the battery cells in this segment by the upper monitoring platform 30. At the same time, each monitoring module 20 can also be connected in series to achieve the expansion of the monitoring modules 20. Therefore, the power battery monitoring system can select the number of the monitoring modules 20 according to the specific number of the battery cells, is compatible with the battery modules 10 with various configurations, and has better compatibility.

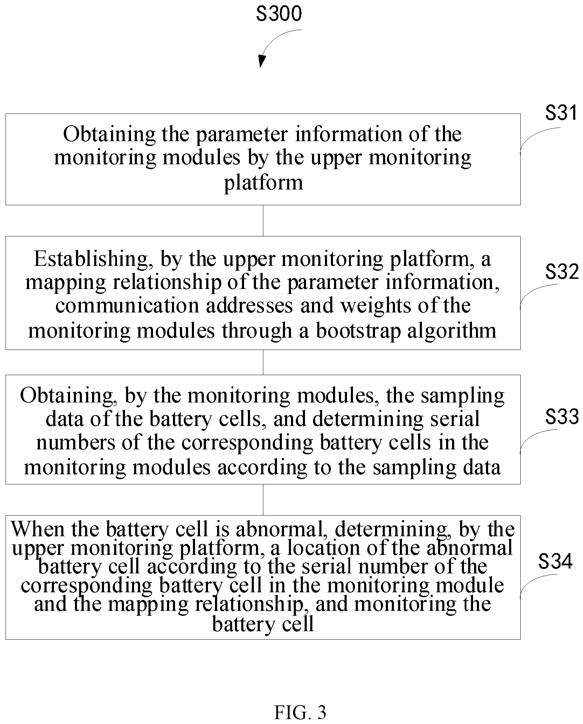

As shown in Fig. 3, Fig. 3 is a flow chart of a power battery monitoring method provided by an embodiment of the present application and applied to the above power battery monitoring system. As shown in Fig, 3, the method S300 comprises:

S31, obtaining the parameter information of the monitoring modules by the upper monitoring platform.

The parameter information of the monitoring modules comprises the types and the number of the sampling channels of the monitoring modules. The parameter information of the monitoring modules can be stored in the monitoring modules in advance, and can be obtained directly by the upper monitoring platform. The parameter information of the monitoring modules can also be counted in real time, and transmitted to the supreme monitoring platform after the type and corresponding number of the sampling channels are determined. If there are N monitoring modules, the upper monitoring platform obtains the parameter information of each monitoring module respectively, and registers and records the parameter information accordingly.

In some embodiments, before the upper monitoring platform obtains the parameter information of the monitoring modules, the type of the sampling channels can be detected in advance and the corresponding number can be counted. Specifically, the monitoring modules obtain the first voltage through the sampling channels. If the first voltage is greater than a first preset threshold or the first voltage is less than a second preset threshold, the sampling channel is determined as the voltage sampling channel and the number of the voltage sampling channels is counted. The remaining sampling channels are determined as the temperature sampling channels, and the number of the temperature sampling channels is counted.

If the first voltage is greater than the first preset threshold, the sampling channels are voltage sampling channels and in all voltage sampling channels, the first voltage sampling channel is the P line (with the lowest voltage), and the last voltage sampling channel is the Q line (with the highest voltage).

If the first voltage is less than a second preset threshold, the sampling channels are voltage sampling channels, and in all voltage sampling channels, the last voltage sampling channel is the P line (with the lowest voltage), and the first voltage sampling channel is the Q line (with the highest voltage).

Wherein the first preset threshold and the second preset threshold can be set as needed. In the embodiment of the present application, the first preset threshold is 1.0 V, and the second preset threshold is -1.0 V.

In other embodiments, the parameter information of the monitoring modules also comprises the number of multiplexing sampling channels. The monitoring modules can store the number of the voltage sampling channels, the number of the temperature sampling channels and the number of the multiplexing sampling channels in advance, and transmit the number of the sampling channels to the upper monitoring platform for the upper monitoring platform to record.

S32, establishing, by the upper monitoring platform, a mapping relationship of the parameter information, communication addresses and weights of the monitoring modules through a bootstrap algorithm.

If the number of the monitoring modules is N and the N monitoring modules are connected in series, each monitoring module corresponds to a segment of the battery cells, but the segment sequences of the monitoring modules and the battery cells are not necessarily in one-to-one correspondence. Therefore, the sequence of the monitoring modules can be identified through the bootstrap algorithm to make it consistent with the segment sequence of the battery cells, and assign the corresponding communication address to the monitoring modules based on the sequence.

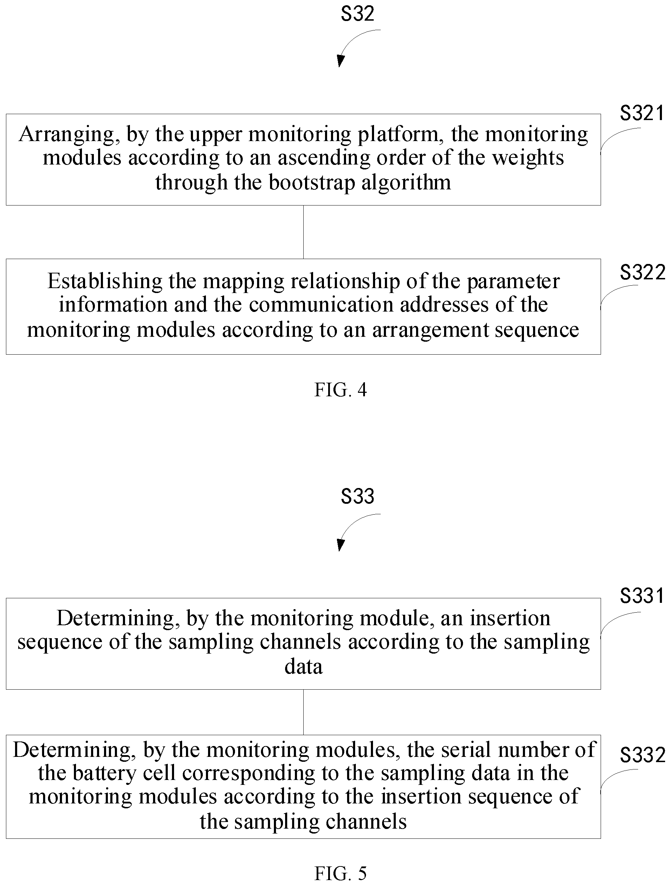

Specifically, as shown in Fig. 4, step S32 comprises:

S321, arranging, by the upper monitoring platform, the monitoring modules according to an ascending order of the weights through the bootstrap algorithm.

The battery cells are divided into multiple segments in order, and each segment is connected with the same monitoring module. The higher the segment sequence is, the smaller the weight w is and the higher the sequence of the monitoring module is. The communication addresses are assigned for the monitoring modules according to the sequence of the arranged monitoring modules. For example: the monitoring module 1 is connected with the battery cells of the third segment, and the third segment has 7 battery cells; the monitoring module 2 is connected with the battery cells of the first segment, and the first segment has 6 battery cells; the monitoring module 3 is connected with the battery cells of the second segment, and the second segment has 6 battery cells. Then the upper monitoring platform obtains the weight w of each monitoring module through the bootstrap algorithm, and arranges the monitoring modules in ascending order of the weight w. Therefore, the sequence of the monitoring modules is the monitoring module 2, the monitoring module 3, and the monitoring module 1. The communication addresses are assigned for the monitoring modules according to this sequence. The communication address of the monitoring module 2 is id100 and serial number is 1; the communication address of the monitoring module 3 is id101 and serial number is 2; and the communication address of the monitoring module 1 is id102 and serial number is 3.

S322, establishing the mapping relationship of the parameter information and the communication addresses of the monitoring modules according to an arrangement sequence.

The mapping relationship of the parameter information and the assigned communication addresses of the monitoring modules is established according to an ascending order, which can be specifically realized through a table. After the table is completed, the mapping relationship is stored in the upper monitoring platform for subsequent operation.

Specifically, if there are three monitoring modules in the above embodiment, the mapping table is shown in Table 1:

Table 1: Mapping Table

| Serial number | Monitoring module | CAN id | Weight w | Number of voltage sampling channels | Number of temperature sampling channels |
|---------------|-------------------|--------|----------|-------------------------------------|-----------------------------------------|
| 1 | Monitoring module 2 | id100 | w1 | 24 | 0 |
| 2 | Monitoring module 3 | id101 | w2 | 24 | 0 |
| 3 | Monitoring module 1 | id102 | w3 | 10 | 2 |

The monitoring module 2 corresponds to the first segment of battery cells, with serial number of 1 and the communication address of id100. The number of the voltage sampling channels is 24. The monitoring module 3 corresponds to the second segment of battery cells, with serial number of 2 and the communication address of id101. The number of the voltage sampling channels is 24. The monitoring module 1 corresponds to the third segment of battery cells, with serial number of 3 and the communication address of id102. The number of the voltage sampling channels is 10 and the number of the temperature sampling channels is 2.

S33, obtaining, by the monitoring modules, the sampling data of the battery cells, and determining serial numbers of the corresponding battery cells in the monitoring modules according to the sampling data.

The monitoring modules and the battery cells are connected through the cable plugs. One end of the cable plugs is connected with a certain segment of battery cells in the battery module. The sequence of the sampling channels in the cable plugs is consistent with the sequence of the battery cells in this segment. The other end of the cable plugs is inserted into the monitoring modules by a positive sequence or reverse sequence. The sequence in which the cable plugs are inserted into the monitoring modules can be determined by the sampling voltage obtained from the sampling channel or channel resistance between the sampling channels.

Specifically, as shown in Fig. 5, step S33 comprises:

S331, determining, by the monitoring module, an insertion sequence of the sampling channels according to the sampling data.

The insertion sequence of the sampling channels is the sequence in which the cable plugs are inserted into the monitoring modules in the above embodiment, which comprises a positive insertion sequence and a reverse insertion sequence, and the specific insertion sequence of the sampling channels can be determined by the sampling data.

Specifically, a detection method of the insertion sequence is:

(1) obtaining the first sampling voltage of the first sampling channel; if the first sampling voltage is greater than a third preset threshold, determining the insertion sequence of the sampling channels as the positive insertion sequence; if the first sampling voltage is less than a fourth preset threshold, determining the insertion sequence of the sampling channels as the reverse insertion sequence; otherwise, going to (2);

(2) obtaining the second sampling voltage of the last sampling channel; if the second sampling voltage is less than the fourth preset threshold, determining the positive insertion sequence; if the second sampling voltage is greater than the third preset threshold, determining the reverse insertion sequence; otherwise, going to (3);

(3) detecting the first 8 sampling channels in the sampling channels, obtaining the channel resistance between the sampling channels, and obtaining the channel resistance in a set {(1,2),(3,4),(5,6),(7,8)}; if there is a channel resistance greater than a fifth preset threshold and less than a sixth preset threshold, determining the reverse insertion sequence; otherwise, going to (4);

(4) if there are M sampling channels, obtaining the channel resistance in a set {(M-7,M-6),(M-5,M-4),(M-3,M-2),(M-1,M)}; if there is a channel resistance greater than the fifth preset threshold and less than the sixth preset threshold, determining the positive insertion sequence; otherwise, going to (5);

(5) making the cable plugs not connected with the battery modules or not inserted into the monitoring modules.

Wherein the third preset threshold, the fourth preset threshold, the fifth preset threshold and the sixth preset threshold can be set as required. In the embodiment of the present application, the third preset threshold, the fourth preset threshold, the fifth preset threshold and the sixth preset threshold are 1V, -1V, 100 Ω, and 10 MΩ respectively.

S332, determining, by the monitoring modules, the serial number of the battery cell corresponding to the sampling data in the monitoring modules according to the insertion sequence of the sampling channels.

If the sampling channels are inserted in the positive sequence, the serial numbers of the sampling channels are consistent with the serial numbers of the corresponding battery cells in the monitoring modules; if the sampling channels are inserted in the reverse sequence, the serial numbers of the sampling channels are also in reverse order with the serial numbers of the corresponding battery cells in the monitoring modules.

For example, if the monitoring module has eight sampling channels and the cable plugs are inserted in a positive sequence, the battery cell corresponding to the first sampling channel is the first battery cell, and the serial number in the monitoring module is 1. If the cable plugs are inserted in a reverse sequence, the battery cell corresponding to the first sampling channel is the last battery cell in the corresponding battery cell segment of the monitoring module, that is, the serial number of the eighth battery cell in the segment of the bacterial cells is 8 in the monitoring module.

S34, when the battery cell is abnormal, determining, by the upper monitoring platform, a location of the abnormal battery cell according to the serial number of the corresponding sampling channel and the mapping relationship, and monitoring the battery cell.

According to the obtained sampling data, it is determined whether the corresponding battery cell is abnormal. If the battery cell is abnormal, the specific location of the abnormal battery cell is determined to facilitate processing of the abnormal battery cell. The specific location of the battery cell is determined according to the serial number of the corresponding sampling channel in the monitoring module and the number of the sampling channels in each monitoring module.

Specifically, as shown in Fig. 6, step S34 comprises:

S341, if the abnormal battery cell corresponds to the kth monitoring module, obtaining, by the upper monitoring platform, the number of the sampling channels of the first k-1 monitoring modules according to the mapping relationship;

S342, determining the location of the abnormal battery cell through the following formula:

$$C(n) = \sum_{1}^{k-1} M(k) + i$$

wherein M(k) is the number of the sampling channels of the kth monitoring module, i is the serial number of the abnormal battery cell in the kth monitoring module, and C(n) is the serial number of the location of the abnormal battery cell in all the battery cells.

That is, the location number of the abnormal battery cell in all battery cells can be n, and the location number of the nth battery cell in all battery cells can be determined according to the number of the sampling channels of the first k-1 monitoring modules and the sequence of the abnormal unit in the kth monitoring module because the abnormal battery cell corresponds to the kth monitoring module.

To sum up, the power battery monitoring method can segment the battery cells; the number of the battery cells in each segment is M; the battery cells in each segment are connected with the same monitoring module; and the monitoring modules obtain the sampling data of the battery cells in this segment through the corresponding sampling channel, so as to realize the monitoring of the battery cells in this segment by the upper monitoring platform. At the same time, each monitoring module can also be connected in series to achieve the expansion of the monitoring modules. Therefore, the power battery monitoring system can select the number of the monitoring modules according to the specific number of the battery cells, is compatible with the battery modules with various configurations, and has better compatibility.

It should be noted that in each of the above embodiments, there is not necessarily a certain sequence between the above steps. Those ordinary skilled in the art can understand according to the description of the embodiments of the present application that in different embodiments, the above steps can have different execution sequences, that is, they can be executed in parallel, or executed in exchange, and so on.

As another aspect of the embodiment of the present application, the embodiment of the present application provides a power battery monitoring device. Wherein the power battery monitoring device can be a software module; the software module comprises a plurality of instructions which are stored in a memory of electrical modulation; and a processor can access the memory, and call the instructions for execution, to complete the power battery monitoring method illustrated in the above embodiments.

In some embodiments, the power battery monitoring device may also be built by hardware devices. For example, the power battery monitoring device may be built by one or more chips, and each chip may work in coordination with each other to complete the power battery monitoring method illustrated in the above embodiments. For example, the power battery monitoring device can also be built by various logic devices, such as a general-purpose processor, a digital signal processor (DSP), an application-specific integrated circuit (ASIC), a field programmable gate array (FPGA), a single-chip microcomputer, an ARM (Acorn RISC Machine) or other programmable logic devices, a discrete gate or transistor logic, a discrete hardware component, or any combination of these components.

As shown in Fig. 7, Fig. 7 shows a power battery monitoring device provided by an embodiment of the present application. The power battery monitoring device 700 comprises a first acquisition module 701, an establishment module 702, a first determination module 703 and a second determination module 704.

The first acquisition module 701 is used for the upper monitoring platform to obtain the parameter information of the monitoring modules.

The establishment module 702 is used for the upper monitoring platform to establish the mapping relationship of the parameter information, the communication address and the weight of the monitoring modules through the bootstrap algorithm.

The first determination module 703 is used for the monitoring modules to obtain the sampling data of the battery cells and determine the serial number of the corresponding battery cell in the monitoring module according to the sampling data.

The second determination module 704 is used for determining, by the upper monitoring platform, a location of the abnormal battery cell according to the serial number of the corresponding battery cell in the monitoring module and the mapping relationship when the battery cell is abnormal, and monitoring the battery cell.

Therefore, the power battery monitoring device can segment the battery cells; the number of the battery cells in each segment is M; the battery cells in each segment are connected with the same monitoring module; and the monitoring modules obtain the sampling data of the battery cells in this segment through the corresponding sampling channel, so as to realize the monitoring of the battery cells in this segment by the upper monitoring platform. At the same time, each monitoring module can also be connected in series to achieve the expansion of the monitoring modules. Therefore, the power battery monitoring system can select the number of the monitoring modules according to the specific number of the battery cells, is compatible with the battery modules with various configurations, and has better compatibility.

It should be noted that since the power battery monitoring device and the power battery monitoring method in the above embodiments are based on the same inventive idea, the corresponding contents in the above method embodiments are also applicable to the device embodiments and are not detailed here.

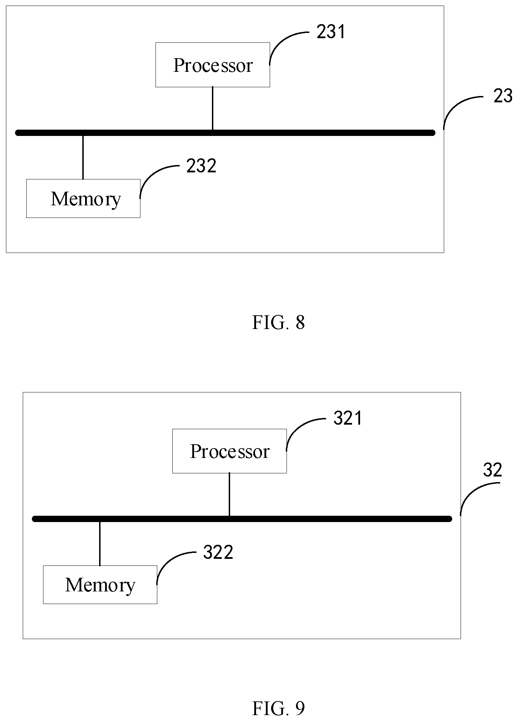

As shown in Fig. 8, Fig. 8 is a structural schematic diagram of a first controller provided by an embodiment of the present application. As shown in Fig. 8, the first controller 23 comprises one or more processors 231 and a memory 232, wherein one processor 231 is taken as an example in Fig. 8.

The processor 231 and the memory 232 can be connected by a bus or other means, wherein connection by the bus is taken as an example in Fig. 8.

The memory 232, as a non-volatile computer-readable storage medium, can be used to store non-volatile software programs, non-volatile computer-executable programs and modules, such as program instructions/modules corresponding to the power battery monitoring method in the embodiments of the present application. The processor 231 performs various functional applications and data processing of the power battery monitoring device by running the non-volatile software programs, instructions and modules stored in the memory 232, thereby realizing the functions of the power battery monitoring method provided by the above method embodiments and the functions of each module or unit of the above device embodiments.

The memory 232 may comprise a high-speed random access memory and may also comprise a non-volatile memory, such as at least one disk storage device, flash memory device, or other non-volatile solid-state storage devices. In some embodiments, the memory 232 optionally comprises memories remotely arranged relative to the processor 231, and these remote memories may be connected to the processor 231 through a network. Examples of the network comprise, but are not limited to, the Internet, corporate Intranet, local area networks, mobile communication networks and their combinations.

The program instructions/modules are stored in the memory 232 and, when executed by the one or more processors 231, perform the power battery monitoring method in any of the method embodiments.

As shown in Fig. 9, Fig. 9 is a structural schematic diagram of a second controller provided by an embodiment of the present application. The structure of the second controller 32 is similar to the structure of the first controller 23 in Fig. 8 and will not be repeated here, wherein the processor and the memory in the second controller 32 can also be the same as the processor and the memory in the first controller 23.

An embodiment of the present application further provides a power battery monitoring device, comprising at least one processor; and a memory which is in communication connection with the at least one processor, wherein the memory stores instructions that can be executed by the at least one processor, and the instructions are executed by the at least one processor to enable the at least one processor to perform any of the power battery monitoring methods.

An embodiment of the present application further provides a computer-readable storage medium that stores computer-executable instructions, and the computer-executable instructions are used to enable a computer to perform the power battery monitoring method.

An embodiment of the present application further provides a computer program product, comprising a computer program stored on a non-volatile computer-readable storage medium; and the computer program comprises program instructions which, when executed by a controller, enable the controller to perform any of the power battery monitoring methods.

Through the above description of the embodiments, those ordinary skilled in the art can clearly understand that the embodiments can be realized by means of software and common hardware platforms, and of course, by hardware. Those ordinary skilled in the art may understand that all or part of the processes in the methods of the embodiments may be completed by instructing the relevant hardware by means of a computer program in a computer program product. The computer program may be stored in a nontransient computer-readable storage medium, and the computer program comprises program instructions. When the program instructions are executed by an unmanned aerial vehicle (UAV), the UAV can perform the processes of the embodiments of the methods. Wherein the storage medium may be a disk, an optical disc, a read-only memory (ROM) or a random access memory (RAM).

Finally, it should be noted that the above embodiments are used only to illustrate the technical solution of the present application, and not to limit it. Under the idea of the present application, the above embodiments or the technical features in different embodiments can be combined, the steps can be implemented in any order, and there are many other changes in different aspects of the present application as described above, which are not provided in detail for the sake of brevity. Although the present application is described in detail by reference to the above embodiments, it should be understood by those ordinary skilled in the art that they may modify the technical solution recorded in the above embodiments or make equivalent replacements for some of the technical features. These modifications or replacements shall not make the corresponding technical solution depart from the scope of the technical solution of each embodiment of the present application.

The above only describes the specific embodiments of the present application, but the protection scope of the present application is not limited to this. Any changes or replacements that can be easily contemplated by those skilled in the art within the technical scope disclosed in the present application shall be covered within the protection scope of the present application. Therefore, the protection scope of the present application shall depend on the protection scope of the claims.

**Claims**

1.  A power battery monitoring system, **characterized by** comprising a battery module, N monitoring modules and an upper monitoring platform:

    wherein the battery module comprises a plurality of battery cells connected in series and parallel;
    the N monitoring modules are connected in series with each other, and a first monitoring module is connected with the upper monitoring platform,
    wherein the number of sampling channels of each monitoring module is M; M battery cells are connected with the same monitoring module through the M sampling channels; a sequence of the M sampling channels is consistent with a sequence of the M battery cells; M and N are integers greater than or equal to 1 respectively; and the monitoring modules are used for obtaining the sampling data of the battery cells;
    the upper monitoring platform is used for monitoring the battery modules according to the sampling data.

2.  The power battery monitoring system according to claim 1, **characterized in that** the sampling data comprises voltage or the voltage and temperature, and the monitoring modules comprise a voltage sampling unit, a temperature sampling unit and a first controller;

    one end of the voltage sampling unit is connected with the battery cell through the sampling channel, and the other end is connected with the first controller for sampling the voltage of the battery cell;
    one end of the temperature sampling unit is connected with the battery cells through the sampling channels, and the other end is connected with a first controller for sampling the temperature of the battery cells; and
    the first controller is also connected with the upper monitoring platform, and the first controller is used for obtaining the voltage or the voltage and the temperature.

3.  The power battery monitoring system according to claim 2, **characterized in that** the M sampling channels are voltage sampling channels; or, the M-P sampling channels are the voltage sampling channels, and the P sampling channels are temperature sampling channels; or the M-R sampling channels are the voltage sampling channels, and the R sampling channels are multiplexing sampling channels.

4.  The power battery monitoring system according to claim 2, **characterized in that** the temperature sampling unit adopts a PTC resistor or an NTC resistor.

5.  The power battery monitoring system according to any one of claims 1-4, **characterized in that** the monitoring modules further comprise a first communication unit, the first communication unit is in communication connection with the first controller and the upper monitoring platform respectively, and a communication type is CAN communication or CAN FD communication.

6.  The power battery monitoring system according to any one of claims 1-4, **characterized in that** the upper monitoring platform comprises a second controller and a second communication unit;

    the second communication unit is in communication connection with the monitoring modules and the second controller respectively to obtain the sampling data;
    the second controller is used for monitoring the battery modules according to the sampling data.

7.  The power battery monitoring system according to any one of claims 1-4, **characterized in that** the battery cells and the monitoring modules are connected by cable plugs.

8.  A power battery monitoring method, applied to the power battery monitoring system according to any one of claims 1-7, **characterized by** comprising:

    obtaining the parameter information of the monitoring modules by the upper monitoring platform;
    establishing, by the upper monitoring platform, a mapping relationship of the parameter information, communication addresses and weights of the monitoring modules through a bootstrap algorithm;
    obtaining, by the monitoring modules, the sampling data of the battery cells, and determining serial numbers of the corresponding battery cells in the monitoring modules according to the sampling data;
    when the battery cell is abnormal, determining, by the upper monitoring platform, a location of the abnormal battery cell according to the serial number of the corresponding battery cell in the monitoring module and the mapping relationship, and monitoring the battery cell.

9. The power battery monitoring method according to claim 8, **characterized in that** the parameter information of the monitoring modules comprises the number of the voltage sampling channels and the number of the temperature sampling channels; and before the upper monitoring platform obtains the parameter information of the monitoring modules, the method further comprises:
obtaining, by the monitoring modules, a first voltage through the sampling channel; if the first voltage is greater than a first preset threshold or the first voltage is less than a second preset threshold, determining that the sampling channel is the voltage sampling channel and counting the number of the voltage sampling channels; determining the remaining sampling channels as the temperature sampling channel; and counting the number of the temperature sampling channels.

10. The power battery monitoring method according to claim 8, **characterized in that** the establishing, by the upper monitoring platform, a mapping relationship of the parameter information, communication addresses and weights of the monitoring modules through a bootstrap algorithm comprises:

arranging, by the upper monitoring platform, the monitoring modules according to an ascending order of the weights through the bootstrap algorithm;
establishing the mapping relationship of the parameter information and the communication addresses of the monitoring modules according to an arrangement sequence.

11. The power battery monitoring method according to claim 8, **characterized in that** the obtaining, by the monitoring modules, the sampling data of the battery cells, and determining serial numbers of the corresponding battery cells in the monitoring modules according to the sampling data comprises:

determining, by the monitoring module, an insertion sequence of the sampling channels according to the sampling data;
determining, by the monitoring modules, the serial number of the battery cell corresponding to the sampling data in the monitoring modules according to the insertion sequence of the sampling channels.

12. The power battery monitoring method according to any one of claims 8-11, **characterized in that** the determining, by the upper monitoring platform, a location of the abnormal battery cell according to the serial number of the corresponding battery cell in the monitoring module and the mapping relationship comprises:

if the abnormal battery cell corresponds to the kth monitoring module, obtaining, by the upper monitoring platform, the number of the sampling channels of the first k-1 monitoring modules according to the mapping relationship; determining the location of the abnormal battery cell through the following formula:

$$C(n) = \sum_{1}^{k-1} M(k) + i$$

wherein M(k) is the number of the sampling channels of the kth monitoring module, i is the serial number of the abnormal battery cell in the kth monitoring module, and C(n) is the serial number of the location of the abnormal battery cell in all the battery cells.

13. A power battery monitoring device, **characterized by** comprising at least one processor; and

a memory in communication connection with the at least one processor, wherein
the memory stores instructions that can be executed by the at least one processor, and the instructions are executed by the at least one processor to enable the at least one processor to perform the method according to any one of claims 8-12.

14. A computer-readable storage medium, storing computer-executable instructions which are used to enable a computer to perform the method according to any one of claims 8-12.

| Monitoring module 1 | Monitoring module 2 | . . . | Monitoring module N-1 | Monitoring module N |
|---|---|---|---|---|
| 20 | 20 | | 20 | 20 |

Upper monitoring platform 30

10

Monitoring module 20

ch0  ch1  ch2  ch3  ch4  ch5  ch6  ch7

cell1  cell2  cell3  cell4  cell5  cell6  cell7

FIG. 1

20

30

Voltage sampling unit 21

First controller 23

First communication unit 24

Second communication unit 31

Second controller 32

Temperature sampling unit 22

FIG. 2

S300

S31

Obtaining the parameter information of the
monitoring modules by the upper monitoring
platform

S32

Establishing, by the upper monitoring platform, a
mapping relationship of the parameter information,
communication addresses and weights of the
monitoring modules through a bootstrap algorithm

S33

Obtaining, by the monitoring modules, the sampling
data of the battery cells, and determining serial
numbers of the corresponding battery cells in the
monitoring modules according to the sampling data

S34

When the battery cell is abnormal, determining, by the
upper monitoring platform, a location of the abnormal
battery cell according to the serial number of the
corresponding battery cell in the monitoring module
and the mapping relationship, and monitoring the
battery cell

FIG. 3

S32

S321
Arranging, by the upper monitoring platform, the monitoring modules according to an ascending order of the weights through the bootstrap algorithm

S322
Establishing the mapping relationship of the parameter information and the communication addresses of the monitoring modules according to an arrangement sequence

FIG. 4

S33

S331
Determining, by the monitoring module, an insertion sequence of the sampling channels according to the sampling data

S332
Determining, by the monitoring modules, the serial number of the battery cell corresponding to the sampling data in the monitoring modules according to the insertion sequence of the sampling channels

FIG. 5

S34

If the abnormal battery cell corresponds to the kth monitoring module, obtaining, by the upper monitoring platform, the number of the sampling channels of the first k-1 monitoring modules according to the mapping relationship;

S341

Determining the location of the abnormal battery cell through the following formula:

$$C(n) = \sum_1^{k-1} M(k) + i$$

wherein M(k) is the number of the sampling channels of the kth monitoring module, i is the serial number of the abnormal battery cell in the kth monitoring module, and C(n) is the serial number of the location of the abnormal battery cell in all the battery cells.

S342

FIG. 6

| First acquisition module 701 | First determination module 703 |
|---|---|
| Establishment module 702 | Second determination module 704 |

700

FIG. 7

231

Processor

23

232

Memory

FIG. 8

321

Processor

32

322

Memory

FIG. 9

| INTERNATIONAL SEARCH REPORT | International application No. |
|---|---|
| | **PCT/CN2023/081670** |

**A.    CLASSIFICATION OF SUBJECT MATTER**

H01M10/42(2006.01)i;  H01M10/48(2006.01)i;  B60L58/10(2019.01)i

According to International Patent Classification (IPC) or to both national classification and IPC

**B.    FIELDS SEARCHED**

Minimum documentation searched (classification system followed by classification symbols)

IPC: H01M; B60L

Documentation searched other than minimum documentation to the extent that such documents are included in the fields searched

Electronic data base consulted during the international search (name of data base and, where practicable, search terms used)

CNTXT; ENTXT; ENTXTC; DWPI; CNKI: 电池, 电压, 温度, 监控, 兼容, 扩展, 拓展, 上位, 自举算法, battery, voltage, temperature, monitoring, compatibility, expansion, upper computer, bootstrap+ algorithm

**C.    DOCUMENTS CONSIDERED TO BE RELEVANT**

| Category* | Citation of document, with indication, where appropriate, of the relevant passages | Relevant to claim No. |
|---|---|---|
| PX | CN 114914561 A (AUTEL INTELLIGENT TECHNOLOGY CORP., LTD.) 16 August 2022 (2022-08-16)<br>entire document | 1-14 |
| X | CN 107323291 A (SHANDONG UNIVERSITY) 07 November 2017 (2017-11-07)<br>description, paragraphs 4-66, and figures 1-9 | 1-7 |
| X | CN 102200772 A (CHERY AUTOMOBILE CO., LTD.) 28 September 2011 (2011-09-28)<br>description, paragraphs 4-16 | 1-7 |
| A | CN 105843211 A (BEIJING ELECTRIC VEHICLE CO., LTD.) 10 August 2016 (2016-08-10)<br>entire document | 1-14 |
| A | EP 2910962 A1 (SONY CORP.) 26 August 2015 (2015-08-26)<br>entire document | 1-14 |

☐ Further documents are listed in the continuation of Box C.        ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **20 June 2023** | **25 June 2023** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/081670**

| Patent document cited in search report | | | Publication date (day/month/year) | Patent family member(s) | | | Publication date (day/month/year) |
|---|---|---|---|---|---|---|---|
| CN | 114914561 | A | 16 August 2022 | None | | | |
| CN | 107323291 | A | 07 November 2017 | CN | 107323291 | B | 17 December 2019 |
| CN | 102200772 | A | 28 September 2011 | CN | 102200772 | B | 05 September 2012 |
| CN | 105843211 | A | 10 August 2016 | CN | 105843211 | B | 04 June 2019 |
| EP | 2910962 | A1 | 26 August 2015 | US | 2015241516 | A1 | 27 August 2015 |
| | | | | US | 10353010 | B2 | 16 July 2019 |
| | | | | CA | 2880975 | A1 | 21 August 2015 |
| | | | | JP | 2015155859 | A | 27 August 2015 |
| | | | | EP | 2910962 | B1 | 11 September 2019 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210458752